(19) Europäisches Patentamt
European Patent Office
Office européen des brevets

(11) **EP 4 089 496 A1**

(12) **EUROPEAN PATENT APPLICATION**
published in accordance with Art. 153(4) EPC

(43) Date of publication:
**16.11.2022 Bulletin 2022/46**

(21) Application number: **21765499.5**

(22) Date of filing: **26.02.2021**

(51) International Patent Classification (IPC):
***G05B 23/02*** *(2006.01)*

(52) Cooperative Patent Classification (CPC):
**G05B 23/02**

(86) International application number:
**PCT/JP2021/007403**

(87) International publication number:
**WO 2021/177176 (10.09.2021 Gazette 2021/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.03.2020 JP 2020037158**

(71) Applicant: **Canon Kabushiki Kaisha
Ohta-ku
Tokyo 146-8501 (JP)**

(72) Inventors:
• **KAWAMURA, Akihiko
Tokyo 146-8501 (JP)**
• **KOGA, Shinichiro
Tokyo 146-8501 (JP)**

(74) Representative: **WESER & Kollegen
Patentanwälte PartmbB
Radeckestraße 43
81245 München (DE)**

(54) **INFORMATION PROCESSING DEVICE, MONITORING METHOD, PROGRAM, AND ARTICLE MANUFACTURING METHOD**

(57) An information processing apparatus includes an acquisition unit configured to acquire a plurality of time-series data indicating changes in output values of a plurality of sensors from a monitoring target including the plurality of sensors, a model generation unit configured to generate one model indicating a relationship between the plurality of time-series data from each of a plurality of periods in the plurality of time-series data, thereby generating a plurality of models respectively corresponding to the plurality of periods, and a detection unit configured to detect an abnormality of the monitoring target based on the plurality of models and the plurality of time-series data. The plurality of periods can include two periods partially overlapping each other.

**F I G. 6**

EP 4 089 496 A1

**Description**

TECHNICAL FIELD

The present invention relates to an information processing apparatus, a monitoring method, a program, and an article manufacturing method.

BACKGROUND ART

Japanese Patent Laid-Open No. 2017-021702 describes a method of monitoring a failure sign of a device installed in a plant. This method uses a failure sign monitoring apparatus that monitors a failure sign of each device installed in a plant based on measurement data measured by a sensor for measuring the behavior of the device. The failure sign monitoring apparatus divides the activation process of the plant into a plurality of periods based on the operation contents of the process, and displays a failure sign portion of each device by checking, based on measurement data, the validity of a behavior state whenever each period ends. Also, when confirming that the behavior state in each period is valid, the failure sign monitoring apparatus advances to the next period.

To monitor a failure sign, it is possible to generate, based on a plurality of time-series data indicating changes in output values from a plurality of sensors in a given period, a model indicating the relationship between the plurality of time-series data. If a difference between the output value of the model and the output value of a sensor corresponding to the model exceeds a threshold value, this indicates the occurrence of an abnormality (a failure sign or a failure).

In a case in which the model as described above is inappropriate for some reason, if the output value of the inappropriate model and the output value of a sensor are close even when an abnormality has actually occurred, the occurrence of the abnormality cannot be detected. However, it is difficult to verify the inappropriateness of the model. Also, even when an abnormality is detected, there is no guarantee that the model is appropriate.

SUMMARY OF INVENTION

The present invention provides a technique advantageous for detecting the occurrence of an abnormality of a monitoring target with higher accuracy.

One aspect of the present invention relates to an information processing apparatus, and the information processing apparatus comprises an acquisition unit configured to acquire a plurality of time-series data indicating changes in output values of a plurality of sensors from a monitoring target including the plurality of sensors, a model generation unit configured to generate one model indicating a relationship between the plurality of time-series data from each of a plurality of periods in the plurality of time-series data, thereby generating a plurality of models respectively corresponding to the plurality of periods, and a detection unit configured to detect an abnormality of the monitoring target based on the plurality of models and the plurality of time-series data. The plurality of periods can include two periods partially overlapping each other.

BRIEF DESCRIPTION OF DRAWINGS

Fig. 1 is a view showing an example of the arrangement of an information processing apparatus of an embodiment;
Fig. 2A is a view showing an example of the relationship between a monitoring target and the information processing apparatus;
Fig. 2B is a view showing an example of the relationship between a monitoring target and the information processing apparatus;
Fig. 3 is a view showing an example of the arrangement of the information processing apparatus of the embodiment;
Fig. 4 is a view showing the arrangement of the substrate processing apparatus as a monitoring target;
Fig. 5 is a view showing an example of a temperature regulation system as a monitoring target;
Fig. 6 is a view showing an example of the operation of the information processing apparatus;
Fig. 7A is a view showing an example of the output value of a temperature sensor;
Fig. 7B is a view showing an example of the output value of the temperature sensor;
Fig. 8 is a view showing an example of the operation of the information processing apparatus;
Fig. 9 is a view showing an example of the operation of the information processing apparatus;
Fig. 10 is a view showing an example of abnormality detection by the embodiment; and
Fig. 11 is a view showing an example of abnormality detection by a comparative example.

DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made an invention that requires all such features, and multiple such features may be combined as appropriate. Furthermore, in the attached drawings, the same reference numerals are given to the same or similar configurations, and redundant description thereof is omitted.

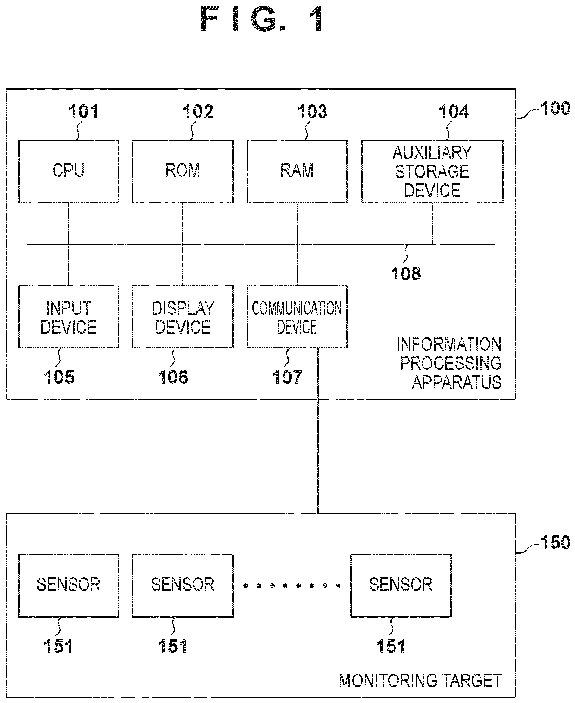

Fig. 1 shows a configuration example of an information processing apparatus 100 of an embodiment. The information processing apparatus 100 can operate as a monitoring apparatus for monitoring the state of a monitoring target 150, or as an apparatus for executing a monitoring method of monitoring the state of the monitoring target 150. The information processing apparatus 100 can be configured by a computer including a memory for storing a program and a processor that operates based on the program. The program can be carried by being stored in a memory medium. Alternatively, the program can be transferred via a communication path such as a network. The information processing apparatus 100 can be configured by either a single computer or a plurality of computers connected to each other via a communication path such as a network, and can also be configured by still another form. In one example, the information processing apparatus 100 can include a CPU 101, a ROM 102, a RAM 103, an auxiliary storage device 104, an input device 105, a display device 106, a communication device 107, and a bus 108.

The CPU 101 can operate based on a program stored in a ROM 102, and can define the function of the information processing apparatus 100. The CPU 101 can communicate with the ROM 102, the RAM 103, the auxiliary storage device 104, the input device 105, the display device 106, and the communication device 107 via the bus 108, and can control these devices. The RAM 103 can be used to temporarily store data. The auxiliary storage device 104 can be a nonvolatile storage device configured by one or a plurality of memory devices. The program for controlling the CPU 101 can also be stored in the auxiliary storage device 104. The memory device can include, for example, an HDD (Hard Disk Drive), a memory disk and/or a memory card.

The input device 105 can include a keyboard, a pointing device, a scanner, or the like. The display device 106 can include a liquid crystal monitor, an organic EL monitor, or the like. The communication device 107 has a function of communicating with an external device. The communication device 107 can communicate with the monitoring target 150 via a communication path such as a network. For example, the communication device 107 can acquire or receive, from the monitoring target 150, a plurality of time-series data indicating changes in output values of a plurality of sensors 151 of the monitoring target 150. The monitoring target 150 can be a manufacturing apparatus for manufacturing an article, such as a substrate processing apparatus. This substrate processing apparatus can be, for example, an exposure apparatus, a pattern formation apparatus such as an imprinting apparatus, or a lithography apparatus.

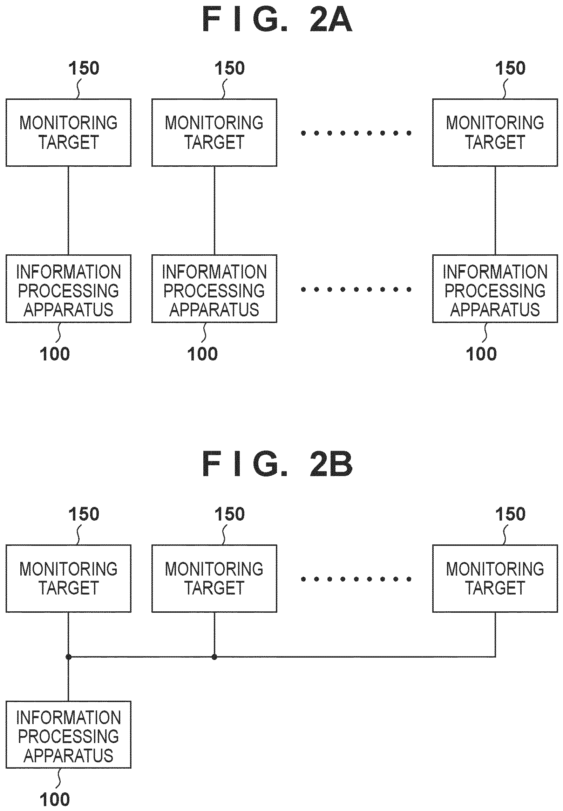

As shown in Fig. 2A, one information processing apparatus 100 for monitoring one monitoring target 150 can be installed. Alternatively, as shown in Fig. 2B, one information processing apparatus 100 for monitoring a plurality monitoring targets 150 can be installed. In addition, although not shown, the information processing apparatus 100 can also be incorporated into the monitoring target 150.

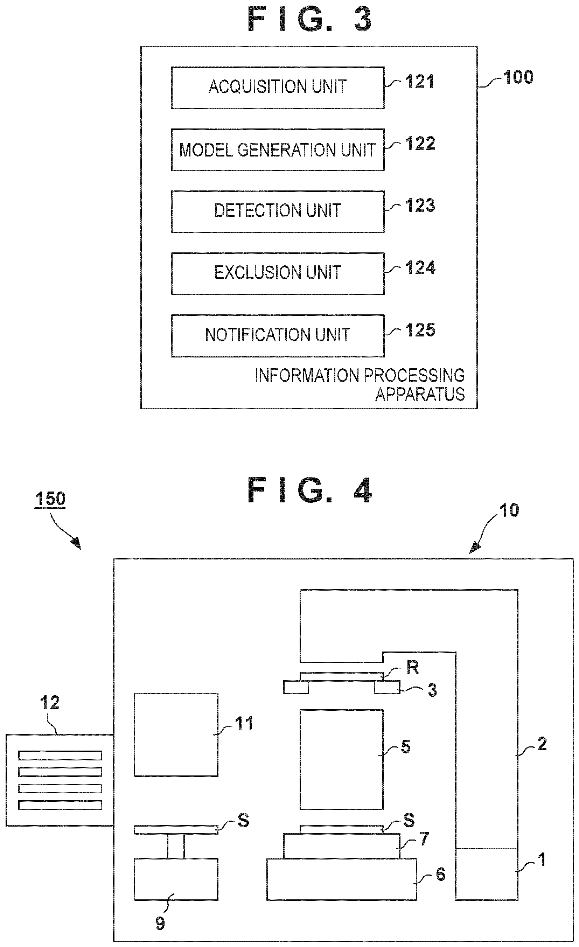

Fig. 3 shows a configuration example according to another viewpoint of the information processing apparatus 100. The information processing apparatus 100 can include an acquisition unit 121, a model generation unit 122, and a detection unit 123. The acquisition unit 121 can be configured to acquire, from the monitoring target 150 including the plurality of sensors 151, a plurality of time-series data indicating changes in output values of the plurality of sensors 151. The model generation unit 122 can generate one model indicating the relationship between the plurality of time-series data from each of a plurality of periods in the plurality of time-series data, thereby generating a plurality of models corresponding to the plurality of periods. The detection unit 123 can detect an abnormality of the monitoring target 150 based on the plurality of models and the plurality of time-series data. The information processing apparatus 100 can further include an exclusion unit 124 for excluding a model that is not used to detect an abnormality of the monitoring target 150. The information processing apparatus 100 can further include a notification unit 125 for notifying that the detection unit 123 has detected an abnormality of the monitoring target 150.

The acquisition unit 121 can acquire error information indicating the occurrence of an error from the monitoring target 150, and the model generation unit 122 can determine the plurality of periods during a period in which no error is occurring. The monitoring target 150 can have an error detecting function of detecting the occurrence of an error, and error information can be provided by this error detecting function. By determining the plurality of periods during the period in which no error is occurring, it is possible to prevent a model from being generated based on inappropriate time-series data.

The model generation unit 122 can also determine the plurality of periods so that they partially overlap each other. This is advantageous to shorten the period required to generate a plurality of models.

The exclusion unit 124 can be configured to exclude, from a plurality of models, a model that is not used to detect an abnormality of the monitoring target 150. The exclusion unit 124 can determine a model to be excluded based on, for example, a time having elapsed since the model generation unit 122 generated a model. For example, the exclusion unit 124 can determine, as a model to be excluded, a model for which the time having elapsed since the model generation unit 122 generated a model has exceeded a predetermined time. If there is no exclusion unit 124, the number of models keeps increasing. Also, if there is no exclusion unit 124. an old model exerts influence on abnormality detection, and this may decrease the sensitivity of the monitoring target 150 and/or the sensor to a change with time.

The detection unit 123 can calculate a difference between the output value of each of the plurality of sensors and an output value given by a model. If a value obtained by processing this difference exceeds a predetermined value, the detection unit 123 can detect the occurrence of an abnormality of the monitoring target 150.

The exclusion unit 124 can determine, for example, a model for which the frequency of an output value at which the occurrence of an abnormality is detected has exceeded a predetermined frequency, as a model to be excluded. For example, the exclusion unit 124 can determine a model to be excluded, from at least three models corresponding to at least three periods arranged in the order of time elapsed in a plurality of periods, based on frequencies at which the occurrence of an abnormality is detected by using the at least three models. As an example, the exclusion unit 124 can determine a threshold value based on the frequencies at which the occurrence of an abnormality is detected by using at least three models. Then, the exclusion unit 124 can determine, as a model to be excluded, a model having generated a frequency exceeding the threshold value among the frequencies at which the occurrence of an abnormality is detected by using the at least three models.

The exclusion unit 124 can also determine, based on a threshold value determined based on an abnormal value calculated by using each of the already existing models, whether to exclude a model to be generated by the model generation unit 122 after that.

The detection unit 123 can calculate an evaluation value while weighting a plurality of differences calculated by using a plurality of models (that is, differences between sensor output values and output values generated by the models), and can detect the state of the monitoring target 150 based on the evaluation value. The detection unit 123 can also perform the weighting based on the time having elapsed since the model generation unit 122 generated a model. The detection unit 123 can decrease the weight as the elapsed time of a model prolongs. Alternatively, the detection unit 123 can decrease the weight as the elapsed time of a model shortens.

The notification unit 125 can be configured to notify that the detection unit 123 has detected an abnormality of the monitoring target 150. Notification like this is advantageous in rapid maintenance of the monitoring target 150.

The information processing apparatus 100 can be understood as an apparatus for executing a method including an acquisition step, a model generation step, and a detection step respectively corresponding to the acquisition unit 121, the model generation unit 122, and the detection unit 123. This method can further include an exclusion method corresponding to the exclusion unit 124 and/or a notification step corresponding to the notification unit 125.

Fig. 4 shows a substrate processing apparatus, and more specifically, shows an example of the monitoring target 150 configured as an exposure apparatus 10. The exposure apparatus 10 can include a light source unit 1 including a light source. This light source can be, for example, a high-pressure mercury lamp or an excimer laser. When the light source is an excimer laser, the light source unit 1 is installed outside a chamber of the exposure apparatus 10 in some cases, but can also be installed inside the chamber.

The exposure apparatus 10 can include an illumination system 2, a reticle stage 3, a projection optical system 5, and a substrate stage 6. The illumination system 2 can illuminate a reticle R held by the reticle stage 3 by using light from the light source unit 1. The illumination optical system 2 can project a pattern of the illuminated reticle R to a substrate S. The substrate stage 6 can include a substrate chuck 7 for holding the substrate S. The substrate stage 6 can position the substrate S by moving in a state in which the substrate S is held by the substrate chuck 7. The exposure apparatus 10 can be configured to exposure the substrate S by either a step-and-repeat method or a step-and-scan method.

The exposure apparatus 10 can be provided with, for example, a substrate cassette 12 holding a plurality of substrates S. The exposure apparatus 10 can include a pre-aligner 9. The exposure apparatus 10 can include a robot (not shown), and the robot can extract the substrate S from the substrate cassette 12 and convey the substrate to the pre-aligner 9. The pre-aligner 9 can perform prealignment (alignment of the direction and the position) of the substrate S. The substrate S pre-aligned by the pre-aligner 9 can be conveyed to the substrate chuck 7 of the substrate stage 6 by the robot.

Another apparatus can also be connected to the exposure apparatus 10. The other apparatus can be a coating/developing apparatus. The substrate S coated with a resist by the coating/developing apparatus can be loaded into the exposure apparatus 10, and the substrate S exposed by the exposure apparatus 10 can be unloaded to the coating/developing apparatus and developed by the coating/developing apparatus.

The exposure apparatus 10 can include a controller 11 for controlling the operation of the exposure apparatus 10. The controller 11 can control, for example, the light source unit, the illumination system 2, the reticle stage 3, the projection optical system 5, the substrate stage 6, and the pre-aligner 9. The controller 11 can communicate with (the communication device 107 of) the information processing apparatus 100. Although not shown in Fig. 4, the exposure apparatus 10 can include a plurality of sensors, and the controller 11 can transmit or provide a plurality of time-series data indicating changes in output values of the plurality of sensors to (the communication device 107 of) the information processing apparatus 100. The plurality of time-series data can also be transmitted or provided to (the communication device 107 of) the information processing apparatus 100 via another apparatus.

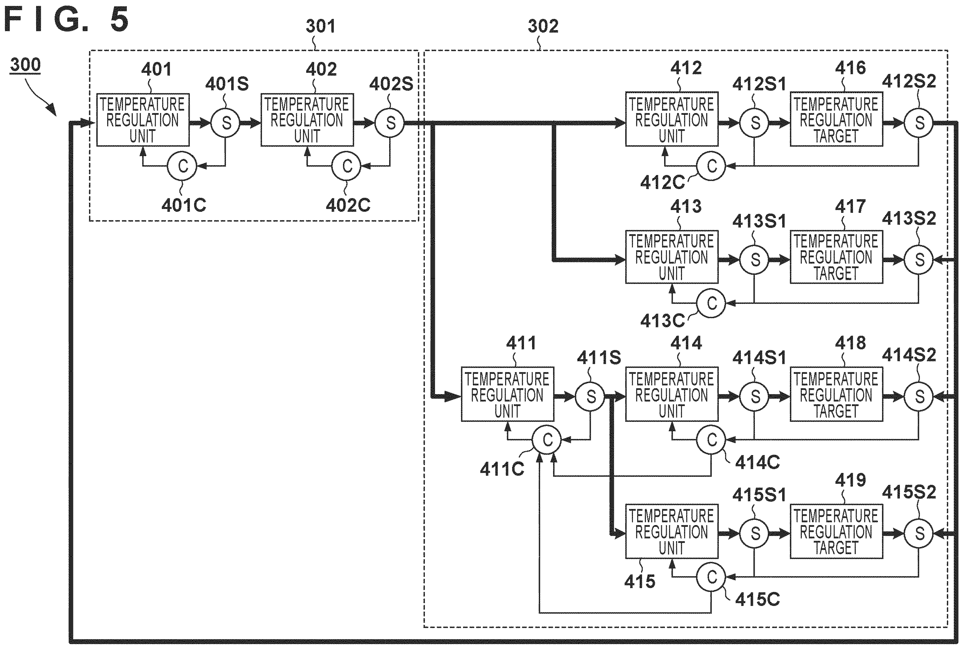

Fig. 5 shows a configuration example of a temperature regulation system 300 incorporated into the exposure apparatus 10 shown in Fig. 4. The temperature regulation system 300 is an example of the monitoring target 150. Referring to Fig. 5, thick-line arrows indicate the flow of a coolant, and thin-line arrows indicate the flow of information. The temperature regulation system 300 can include, for example, a first block 301 and a second block 302. A plurality of temperature regulation targets 416 to 419 can be installed in the second block 302. The plurality of temperature regulation targets 416 to 419 can include, for example, the light source 1, the illumination optical system 2, the reticle stage 3, the projection optical system 5, and the substrate stage 6. The first block 301 can regulate the temperature of a coolant and supply the temperature-regulated coolant to the second block 302. The coolant having the temperature regulated in the first block 301 can perform temperature regulation on one unit or a plurality of units while drawing heat from the one unit or the plurality of units in the second block 302, and can return to the first block 301 after that.

The first block 301 can include, for example, a temperature regulation unit 401, a temperature regulation unit 402, a temperature sensor 401S, a temperature sensor 402, a control unit 401C, and a control unit 402C. The temperature regulation unit 401 can decrease the temperature of the coolant to a target temperature and supply the coolant to the temperature regulation unit 402. The control unit 401C can determine a control amount in accordance with the temperature measured by the temperature sensor 401S such that the temperature of the coolant matches the target temperature, and can operate the temperature regulation unit 401 in accordance with the control amount. The temperature regulation unit 402 can adjust the temperature of the coolant within a temperature range permitted by the second block 302, and supply the coolant to the second block 302. The control unit 402C can determine a control amount in accordance with the temperature measured by the temperature sensor 402S such that the temperature of the coolant falls within the temperature range permitted by the second block 302, and can operate the temperature regulation unit 402 in accordance with the control amount.

In the second block 302, temperature regulation units 412 to 415 can adjust the temperature of the coolant so that temperature regulation targets 416 to 419 fall within the target temperature range. A control unit 412C can determine a control amount in accordance with the temperatures measured by temperature sensors 412S1 and 412S2 so that the temperature regulation target 416 falls within the target temperature range, and can operate the temperature regulation unit 412 in accordance with the control amount. A control unit 413C can determine a control amount in accordance with the temperatures measured by temperature sensors 413S1 and 413S2 so that the temperature regulation target 417 falls within the target temperature range, and can operate the temperature regulation unit 413 in accordance with the control amount.

A control unit 411C can determine a control amount in accordance with the temperature measured by a temperature sensor 411S and information from control units 414C and 415C such that the temperature of the coolant falls within the target temperature range, and can operate the temperature regulation unit 411 in accordance with the control amount. A control unit 414C can determine a control amount in accordance with the temperatures measured by temperature sensors 414S1 and 414S2 such that the temperature regulation target 418 falls within the target temperature range, and can operate the temperature regulation unit 414 in accordance with the control amount. A control unit 415C can determine a control amount in accordance with the temperatures measured by temperature sensors 415S1 and 415S2 such that the temperature regulation target 419 falls within the target temperature range, and can operate the temperature regulation unit 415 in accordance with the control amount.

The temperature regulation units 401, 402, and 412 to 415 can also be heating/cooling units using heat exchange. In another viewpoint, the temperature regulation unit 401 can be a cooling unit, and the temperature regulation units 402 and 412 to 415 can be heating units. The coolant can be either a liquid or a gas.

In the temperature regulation system 300 shown in Fig. 5, the temperature of a temperature regulation target is controlled, and the temperature sensors 401S, 402S, and 411S to 415S2 are installed. However, the temperature regulation system 300 can also include sensors for measuring information other than the temperature (for example, a flow rate sensor, a pressure sensor, an acceleration sensor, and a position sensor). Also, the exposure apparatus 10 can incorporate a control system for controlling a control target in relation to a parameter other than the temperature.

An example of a model to be generated by the model generation unit 122 will be explained below. To simplify the explanation, assume that the output values of two temperature sensors (for example the temperature sensors 401S and 402S) at time t are at and bt in the temperature regulation system shown in Fig. 5. The relationship between the output values at and bt of the two temperature sensors can be defined by a model (function) given by equation (1) below:

$$b_t = f(a_t) \qquad \qquad \qquad ...(1)$$

**EP 4 089 496 A1**

A model f can be, for example, a regression equation determined by a least-squares method or the like based on measurement data measured by the two temperature sensors. Alternatively, the model f can also be, for example, a learning model to be generated by using machine learning. For example, the model f can be a model including a neural network. The neural network is a model having a multilayered network structure including, for example, an input layer, an intermediate layer, and an output layer. A learning model can be obtained by optimizing a combined weighting coefficient or the like inside the neural network in accordance with an algorithm such as an error back propagation method, by using a learning model indicating the relationship between at as input data and bt as training data. The error back propagation method is a method of adjusting the combined weighting coefficient or the like between nodes of each neural network so that a difference between output data and training data decreases. Also, the model f can also be, for example, a learning model including an SVM (Support Vector Machine), instead of a model including a neural network.

A model $f_{ij}(x_j)$ that gives an output value (to be referred to as a predicted output value hereinafter) $x_{ij}$ of a sensor $S_i$ can be given by equation (2) below as a function of an output value (to be referred to as a predicted output value hereinafter) $x_j$ of a sensor $S_j$. In equation (2), i is an integer from 1 to N, N is the number of sensors, and j is an integer from 1 to N except i.

$$x_{ij} = f_{ij}(x_j) \qquad\qquad ...(2)$$

Equation (2) can mean the following equations:

$$x_{12} = f_{12}(x_2)$$

$$x_{13} = f_{13}(x_3)$$

$$x_{14} = f_{14}(x_4)$$

$$x_{1N} = f_{1N}(x_N)$$

$$x_{21} = f_{21}(x_1)$$

$$x_{23} = f_{23}(x_3)$$

$$x_{24} = f_{24}(x_4)$$

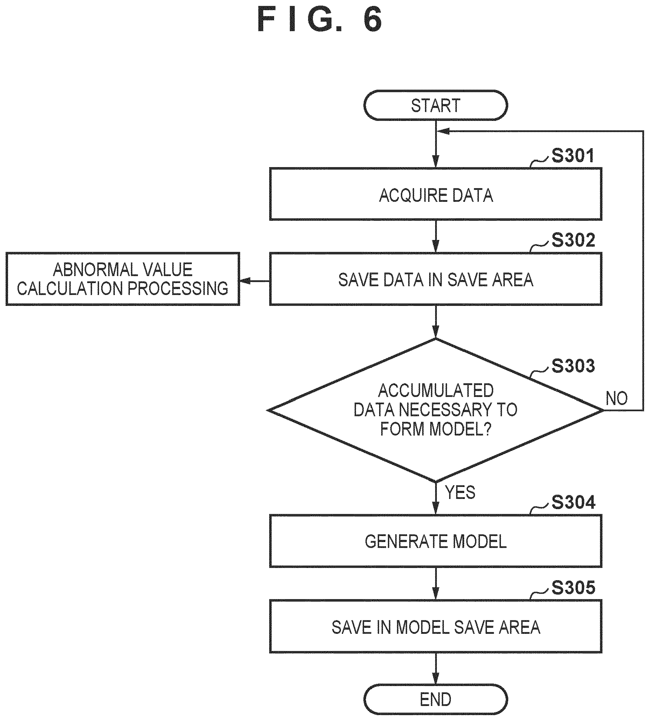

Fig. 6 shows an example of the operation of the information processing apparatus 100 in regard to the generation of a model. In step S301, the information processing apparatus 100 causes the acquisition unit 121 to acquire a plurality of data indicating the output values of a plurality of sensors from the monitoring target 150 including the plurality of sensors. In step S302, the information processing apparatus 100 saves the plurality of data acquired in step S301 in a save area of the auxiliary storage device 104. When the unit of processing including steps S301 and S302 is executed a plurality of times, a plurality of time-series data indicating changes in output values of the plurality of sensors are saved in the save area of the auxiliary storage device 104. Each time-series data contains data obtained by arranging output values of one sensor in a time-series manner. In step S303, the information processing apparatus 100 determines whether the time-series data saved in the save area of the auxiliary storage device 104 has reached an amount necessary to form a model. The information processing apparatus 100 advances to step S304 if the time-series data saved in the save area of the auxiliary storage device 104 has reached the amount necessary to form a model, and returns to step S301 if not.

In step S304, the information processing apparatus 100 causes the model generation unit 122 to generate a plurality of models $f_{ij}(x_j)$ based on the time-series data saved in the save area of the auxiliary storage device 104. In this step, the model generation unit 122 generates one model indicating the relationship between a plurality of time-series data from each of a plurality of periods in the plurality of time-series data, thereby generating the plurality of models $f_{ij}(x_j)$ respectively corresponding to the plurality of periods. In step S305, the information processing apparatus 100 saves the plurality of models $f_{ij}(x_j)$ generated by the model generation unit 122 in step S304 in the save area of the auxiliary storage device 104.

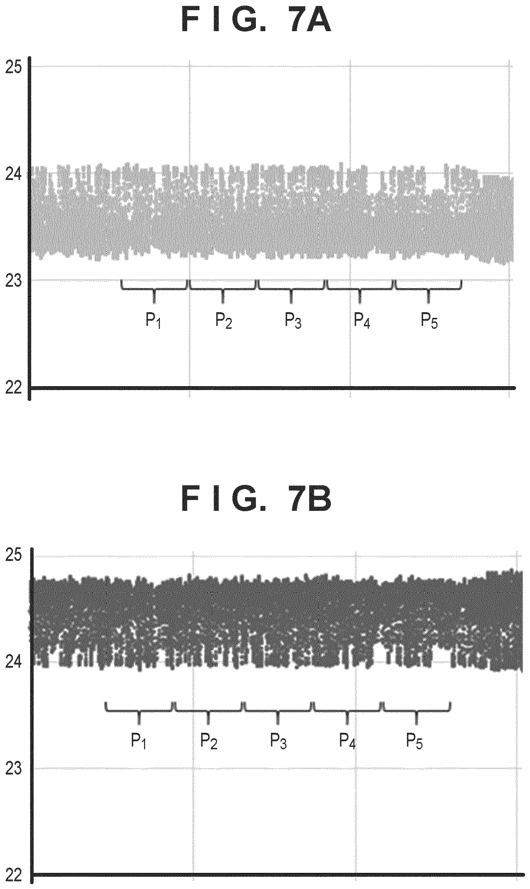

Fig. 7A shows an example of a change in output value of the temperature sensor 401S. Fig. 7B shows an example of a change in output value of the temperature sensor 402S. In Figs. 7A and 7B, the abscissa indicates the time, and the ordinate indicates the output values (values indicating the temperatures) of the temperature sensors 401S and 402S. Periods $P_1$ to $P_5$ are periods for generating a plurality of models. The period $P_1$ is a period for generating one model, the period $P_2$ is a period for generating one model, and the period $P_3$ is a period for generating one model. Also, the period $P_4$ is a period for generating one model, and the period $P_5$ is a period for generating one model.

In one example, output values (data) required to generate one model are output values of 5 days measured at an interval of 5 sec. In this example, each of the periods $P_1$ to $P_5$ is a period of 5 days. The periods $P_1$ to $P_5$ can also be so determined as to have periods overlapping each other. For example, assuming that output values (data) required to generate each model are output values of 5 days, measurement data of 25 days are necessary if the periods $P_1$ to $P_5$ are not overlapped, but output values of 21 days need only be obtained if output values of 1 day are overlapped.

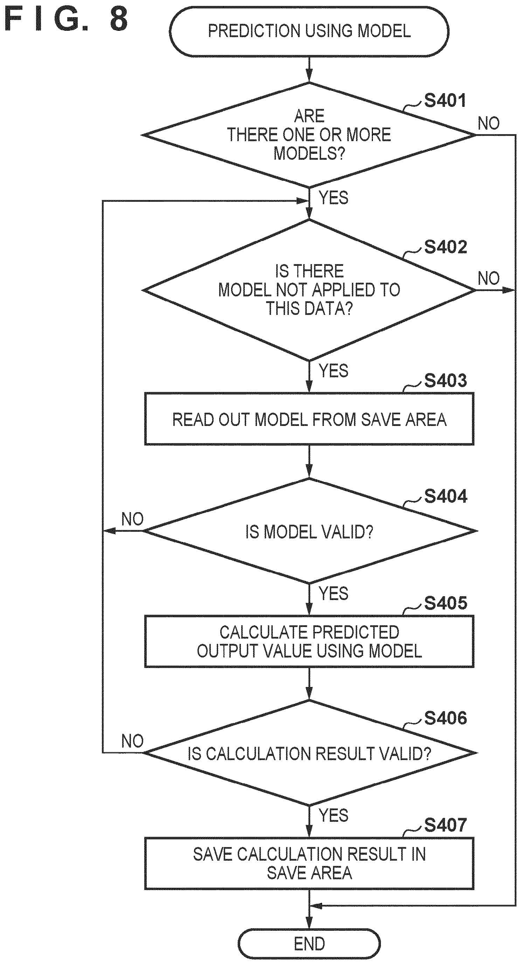

Fig. 8 shows an example of the operation of the information processing apparatus 100 in regard to prediction using a model. The detection unit 123 can execute this processing shown in Fig. 8. In step S401, the information processing apparatus 100 determines whether one or more models generated by the processing shown in Figs. 7A and 7B exist. The information processing apparatus 100 advances to step S402 if one or more models exist, and terminates the processing shown in Fig. 8 if not.

In step S402, the information processing apparatus 100 determines whether a model (unapplied model) not applied to a sensor output value newly acquired by the acquisition unit 121 exists. The information processing apparatus 100 advances to step S403 if the model exists, and terminates the processing shown in Fig. 8 if not. In this step, a sensor output value newly acquired by the acquisition unit 121 is a sensor output value acquired by the acquisition unit 121 after a model was generated. If a model not applied to a sensor output value newly acquired by the acquisition unit 121 does not exist, this means that all models applicable to the output value are already applied to the output value.

In step S404, the information processing apparatus 100 reads out an unapplied model from the save area of the auxiliary storage device 104, and, in step S404, determines whether this unapplied model is valid. The information processing apparatus 100 advances to step S405 if the unapplied model is valid, and terminates the processing shown in Fig. 8 if not. This determination can be performed based on the time having elapsed since the model was generated. For example, if the elapsed time from the generation of a model has exceeded a predetermined time, the information processing apparatus 100 can determine that the model is not valid.

In step S405, the information processing apparatus 100 calculates a predicted output value $x_{ij}$ by using the model $f_{ij}(x_j)$ read out in step S403. Then, in step S406, the information processing apparatus 100 determines whether the predicted output value $x_{ij}$ calculated in step S405 is valid. More specifically, the information processing apparatus 100 can determine that the predicted output value $x_{ij}$ is not valid if the difference or ratio between the predicted output value $x_{ij}$ and the measured output value $x_i$ exceeds a threshold value. If the predicted output value $x_{ij}$ calculated in step S405 is not valid, the information processing apparatus 100 returns to step S402. On the other hand, if the predicted output value $x_{ij}$ calculated in step S405 is valid, the information processing apparatus 100, in step S407, saves the predicted output value $x_{ij}$ calculated in step S405 in the save area of the auxiliary storage device 104.

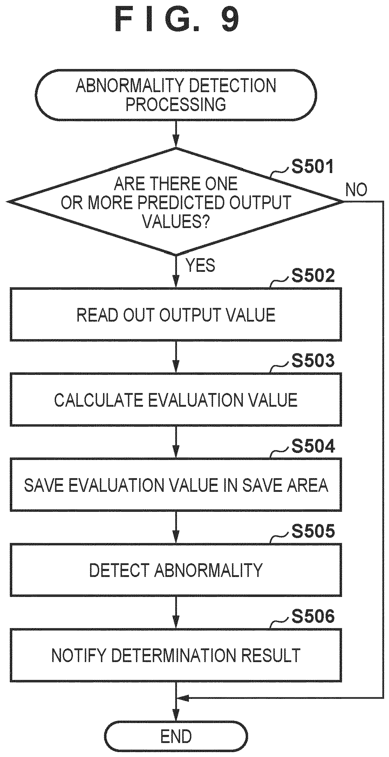

Fig. 9 shows an example of the operation of the information processing apparatus 100 in relation to a process of detecting the occurrence of an abnormality by using a model. The detection unit 123 executes this process shown in Fig. 9. In step S501, the information processing apparatus 100 determines whether one or more predicted output values saved in the save area of the auxiliary storage device 104 exist. The information processing apparatus 100 advances to step S502 if one or more predicted output values exist, and terminates the process shown in Fig. 9 if not.

In step S502, the information processing apparatus 100 reads out the predicted output value saved in the save area of the auxiliary storage device 104. In step S503, the information processing apparatus 100 calculates an evaluation value based on the predicted output value read out in step S502. The evaluation value can be a value obtained by processing the difference between each of a plurality of predicted output values $x_{ij}$ and the measured output value $x_i$ corresponding to the predicted output value xij, for example, a value obtained by normalizing the total value of the differences by the number of a plurality of models. In step S504, the information processing apparatus 100 saves the evaluation value calculated in step S503 in the save area of the auxiliary storage device 104. In step S504, the information processing apparatus 100 detects the occurrence of an abnormality based on the evaluation value calculated in step S503. The information processing apparatus 100 can detect the occurrence of an abnormality if the evaluation value exceeds a predetermined value. In step S505, the information processing apparatus 100 saves the detection result in step S504 in the save area of the auxiliary storage device 104.

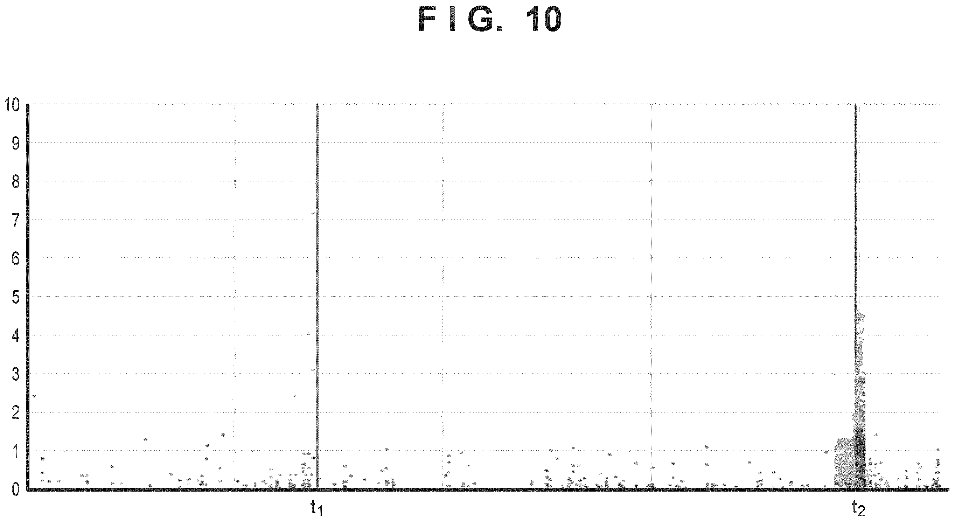

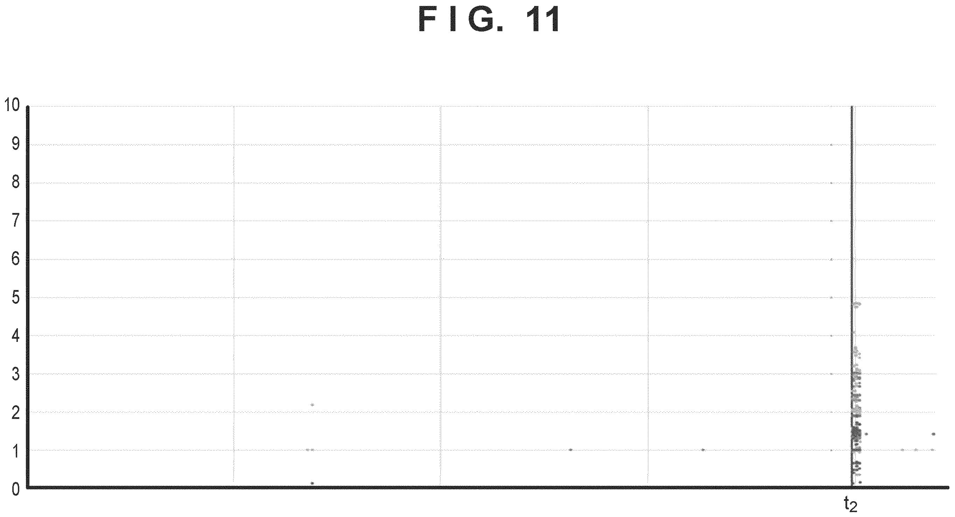

Fig. 10 shows an example of a change in evaluation value calculated in this embodiment. Fig. 11 shows an example of a change in evaluation value in a comparative example. In Figs. 10 and 11, the abscissa indicates the time, and the ordinate indicates the evaluation value. In this embodiment shown in Fig. 10, a plurality of models corresponding to a plurality of periods in a plurality of time-series data are generated by generating one model indicating the relationship between the plurality of time-series data from each of the plurality of periods, and an evaluation value is calculated by using the plurality of models. Evaluation like this using a plurality of models can function to reduce the uncertainty regarding whether each individual model is appropriate. On the other hand, in the comparative example shown in Fig. 11, one model indicating the relationship between a plurality of time-series data is generated from one period in the plurality of time-series data, and an evaluation value is calculated by using this model.

In this embodiment shown in Fig. 10, the occurrence of an abnormality is detected at time t1. In the comparative example shown in Fig. 11, however, no abnormality is detected until time t2 after time t1. That is, this embodiment can detect the occurrence of an abnormality early.

Also, even when an abnormality has actually occurred in the comparative example in a case in which a model generated from one period is inappropriate for some reason, the occurrence of this abnormality cannot be detected if the output value of this inappropriate model and that of a sensor are close. However, it is not easy to verify whether a model is appropriate. In addition, even when an abnormality is detected, there is no guarantee that the model is appropriate.

An article manufacturing method of this embodiment can include an exposure step of exposing a substrate by using an exposure apparatus including a plurality of sensors as a monitoring target, a development step of developing the substrate exposed in the exposure step, and a processing step of obtaining an article by processing the substrate developed in the development step. The article manufacturing method can further include the abovementioned acquisition step and the abovementioned model generation step. The article manufacturing method can also include a detection step of detecting a state of the exposure apparatus as the monitoring target based on the plurality of models and the plurality of time-series data, and a maintenance step of maintaining the exposure apparatus based on the state of the exposure apparatus detected in the detection step.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2020-037158 filed March 4, 2020, which is hereby incorporated by reference herein.

**Claims**

1. An information processing apparatus comprising:

   an acquisition unit configured to acquire a plurality of time-series data indicating changes in output values of a plurality of sensors from a monitoring target including the plurality of sensors;
   a model generation unit configured to generate one model indicating a relationship between the plurality of time-series data from each of a plurality of periods in the plurality of time-series data, thereby generating a plurality of models respectively corresponding to the plurality of periods; and
   a detection unit configured to detect an abnormality of the monitoring target based on the plurality of models and the plurality of time-series data,
   wherein the plurality of periods include two periods partially overlapping each other.

2. The information processing apparatus according to claim 1 wherein

   the acquisition unit acquires error information indicating occurrence of an error from the monitoring target, and
   the model generation unit determines the plurality of periods during a period in which no error is occurring.

3. The information processing apparatus according to claim 1 or 2, further comprising an exclusion unit configured to exclude, from the plurality of models, a model that is not used to detect an abnormality of the monitoring target.

4. The information processing apparatus according to claim 3, wherein the exclusion unit determines a model to be excluded based on an elapsed time from generation of a model by the model generation unit.

5. The information processing apparatus according to claim 3 or 4, wherein the exclusion unit determines a model to be excluded based on a change in output value with time of each of the plurality of sensors.

6. The information processing apparatus according to claim 5, wherein the detection unit calculates a difference between an output value of each of the plurality of sensors and an output value generated by a model.

7. The information processing apparatus according to claim 6, wherein the detection unit detects occurrence of an abnormality in the monitoring target if a value obtained by processing the difference exceeds a predetermined value.

8. The information processing apparatus according to claim 7, wherein the exclusion unit determines, as a model to be excluded, a model for which a frequency of generation of an output value at which the occurrence of an abnormality is detected exceeds a predetermined frequency,

9. The information processing apparatus according to claim 7, wherein the exclusion unit determines a model to be excluded from at least three models respectively corresponding to at least three periods arranged in order of time elapsed among the plurality of periods, based on a frequency at which the occurrence of an abnormality is detected by using the at least three models.

10. The information processing apparatus according to claim 6, wherein the exclusion unit determines, based on a threshold value determined based on a value obtained by processing the difference calculated by using each of already existing models, whether to exclude a model to be generated by the model generation unit thereafter.

11. The information processing apparatus according to claim 6, wherein the detection unit calculates an evaluation value while performing weighting on the plurality of differences respectively calculated by using the plurality of models, and detects a state of the monitoring target based on the evaluation value.

12. The information processing apparatus according to claim 11, wherein the detection unit performs the weighting based on an elapsed time from generation of a model by the model generation unit.

13. The information processing apparatus according to claim 12, wherein the detection unit decreases the weight as the elapsed time of a model prolongs.

14. The information processing apparatus according to claim 12, wherein the detection unit decreases the weight as the elapsed time of a model shortens.

15. The information processing apparatus according to any one of claims 1 to 14, further comprising a notification unit configured to notify that the detection unit has detected an abnormality of the monitoring target.

16. A manufacturing apparatus comprising:

   a substrate processing apparatus including a plurality of sensors; and
   an information processing apparatus defined in any one of claims 1 to 15 and configured to detect a state of the monitoring target.

17. A monitoring method comprising:
   an acquisition step of acquiring a plurality of time-series data indicating changes in output values of a plurality of sensors from a substrate processing apparatus including the plurality of sensors;

   a model generation step of generating one model indicating a relationship between the plurality of time-series data from each of a plurality of periods in the plurality of time-series data, thereby generating a plurality of models respectively corresponding to the plurality of periods; and
   a detection step of detecting an abnormality of the substrate processing apparatus based on the plurality of models and the plurality of time-series data,
   wherein the plurality of periods include two periods partially overlapping each other.

18. A program causing a computer to execute a monitoring method defined in claim 17.

19. An article manufacturing method comprising:

   an exposure step of exposing a substrate by using an exposure apparatus including a plurality of sensors;
   a development step of developing the substrate exposed in the exposure step;
   a processing step of obtaining an article by processing the substrate developed in the development step;

an acquisition step of acquiring a plurality of time-series data indicating changes in output values of the plurality of sensors from the exposure apparatus;

a model generation step of generating one model indicating a relationship between the plurality of time-series data from each of a plurality of periods in the plurality of time-series data, thereby generating a plurality of models respectively corresponding to the plurality of periods;

a detection step of detecting a state of the exposure apparatus based on the plurality of models and the plurality of time-series data; and

a maintenance step of maintaining the exposure apparatus based on the state of the exposure apparatus detected in the detection step,

wherein the plurality of periods include two periods partially overlapping each other.

**Amended claims under Art. 19.1 PCT**

1. (Amended) An information processing apparatus comprising:

    an acquisition unit configured to acquire a plurality of time-series data indicating changes in output values of a plurality of sensors from a monitoring target including the plurality of sensors;

    a model generation unit configured to generate one model indicating a relationship between the plurality of time-series data from each of a plurality of periods in the plurality of time-series data, thereby generating a plurality of models respectively corresponding to the plurality of periods;

    a detection unit configured to detect an abnormality of the monitoring target based on the plurality of models and the plurality of time-series data; and

    an exclusion unit configured to exclude, from the plurality of models, a model that is not used to detect an abnormality of the monitoring target.

2. The information processing apparatus according to claim 1 wherein

    the acquisition unit acquires error information indicating occurrence of an error from the monitoring target, and the model generation unit determines the plurality of periods during a period in which no error is occurring.

3. (Amended) The information processing apparatus according to claim 1 or 2, wherein the plurality of periods include two periods partially overlapping each other.

4. (Amended) The information processing apparatus according to any one of claims 1 to 3, wherein the exclusion unit determines a model to be excluded based on an elapsed time from generation of a model by the model generation unit.

5. (Amended) The information processing apparatus according to any one of claim 1 1 to 4, wherein the exclusion unit determines a model to be excluded based on a change in output value with time of each of the plurality of sensors.

6. The information processing apparatus according to claim 5, wherein the detection unit calculates a difference between an output value of each of the plurality of sensors and an output value generated by a model.

7. The information processing apparatus according to claim 6, wherein the detection unit detects occurrence of an abnormality in the monitoring target if a value obtained by processing the difference exceeds a predetermined value.

8. The information processing apparatus according to claim 7, wherein the exclusion unit determines, as a model to be excluded, a model for which a frequency of generation of an output value at which the occurrence of an abnormality is detected exceeds a predetermined frequency.

9. The information processing apparatus according to claim 7, wherein the exclusion unit determines a model to be excluded from at least three models respectively corresponding to at least three periods arranged in order of time elapsed among the plurality of periods, based on a frequency at which the occurrence of an abnormality is detected by using the at least three models.

10. The information processing apparatus according to claim 6, wherein the exclusion unit determines, based on a threshold value determined based on a value obtained by processing the difference calculated by using each of already existing models, whether to exclude a model to be generated by the model generation unit thereafter.

**11.** The information processing apparatus according to claim 6, wherein the detection unit calculates an evaluation value while performing weighting on the plurality of differences respectively calculated by using the plurality of models, and detects a state of the monitoring target based on the evaluation value.

**12.** The information processing apparatus according to claim 11, wherein the detection unit performs the weighting based on an elapsed time from generation of a model by the model generation unit.

**13.** The information processing apparatus according to claim 12, wherein the detection unit decreases the weight as the elapsed time of a model prolongs.

**14.** The information processing apparatus according to claim 12, wherein the detection unit decreases the weight as the elapsed time of a model shortens.

**15.** The information processing apparatus according to any one of claims 1 to 14, further comprising a notification unit configured to notify that the detection unit has detected an abnormality of the monitoring target.

**16.** A manufacturing apparatus comprising:

a substrate processing apparatus including a plurality of sensors; and
an information processing apparatus defined in any one of claims 1 to 15 and configured to detect a state of the monitoring target.

**17.** (Amended) A monitoring method comprising:
an acquisition step of acquiring a plurality of time-series data indicating changes in output values of a plurality of sensors from a substrate processing apparatus including the plurality of sensors;

a model generation step of generating one model indicating a relationship between the plurality of time-series data from each of a plurality of periods in the plurality of time-series data, thereby generating a plurality of models respectively corresponding to the plurality of periods;
a detection step of detecting an abnormality of the substrate processing apparatus based on the plurality of models and the plurality of time-series data; and
an exclusion unit configured to exclude, from the plurality of models, a model that is not used to detect an abnormality of the substrate processing apparatus.

**18.** A program causing a computer to execute a monitoring method defined in claim 17.

**19.** (Amended) An article manufacturing method comprising:

an exposure step of exposing a substrate by using an exposure apparatus including a plurality of sensors;
a development step of developing the substrate exposed in the exposure step;
a processing step of obtaining an article by processing the substrate developed in the development step;
an acquisition step of acquiring a plurality of time-series data indicating changes in output values of the plurality of sensors from the exposure apparatus;
a model generation step of generating one model indicating a relationship between the plurality of time-series data from each of a plurality of periods in the plurality of time-series data, thereby generating a plurality of models respectively corresponding to the plurality of periods;
a detection step of detecting a state of the exposure apparatus based on the plurality of models and the plurality of time-series data;
a maintenance step of maintaining the exposure apparatus based on the state of the exposure apparatus detected in the detection step; and
an exclusion unit configured to exclude, from the plurality of models, a model that is not used to detect an abnormality of the exposure apparatus.

# F I G. 1

# F I G. 2A

| 150 | 150 | | 150 |
|---|---|---|---|
| MONITORING TARGET | MONITORING TARGET | · · · · · · · · · | MONITORING TARGET |
| INFORMATION PROCESSING APPARATUS | INFORMATION PROCESSING APPARATUS | · · · · · · · · · | INFORMATION PROCESSING APPARATUS |
| 100 | 100 | | 100 |

# F I G. 2B

| 150 | 150 | | 150 |
|---|---|---|---|
| MONITORING TARGET | MONITORING TARGET | · · · · · · · · · | MONITORING TARGET |

INFORMATION PROCESSING APPARATUS

100

# FIG. 3

| | |
|---|---|
| ACQUISITION UNIT | 121 |
| MODEL GENERATION UNIT | 122 |
| DETECTION UNIT | 123 |
| EXCLUSION UNIT | 124 |
| NOTIFICATION UNIT | 125 |

INFORMATION PROCESSING APPARATUS

100

# FIG. 4

150

10

12

11

R

3

5

2

S

S

7

9

6

1

F I G. 5

EP 4 089 496 A1

# F I G. 6

```
                              ┌─────────────┐
                              │    START    │
                              └─────────────┘
                                     │                          ┌──────┐
                                     ▼        ╭─S301             │      │
                              ┌─────────────────────┐           │      │
                              │    ACQUIRE DATA     │           │      │
                              └─────────────────────┘           │      │
                                     │        ╭─S302            │      │
┌──────────────────────┐      ┌─────────────────────┐          │      │
│   ABNORMAL VALUE     │◄─────│ SAVE DATA IN SAVE AREA│         │      │
│CALCULATION PROCESSING│      └─────────────────────┘          │      │
└──────────────────────┘             │                         │      │
                                     ▼           ╭─S303         │      │
                                    ╱╲                          │      │
                                   ╱  ╲  ACCUMULATED            │      │
                                  ╱    ╲ DATA NECESSARY TO   NO │      │
                                  ╲    ╱ FORM MODEL?  ──────────┘
                                   ╲  ╱
                                    ╲╱
                                     │ YES     ╭─S304
                              ┌─────────────────────┐
                              │   GENERATE MODEL    │
                              └─────────────────────┘
                                     │        ╭─S305
                              ┌─────────────────────┐
                              │ SAVE IN MODEL SAVE AREA│
                              └─────────────────────┘
                                     │
                              ┌─────────────┐
                              │     END     │
                              └─────────────┘
```

# F I G. 7A

# F I G. 7B

**F I G. 8**   ( PREDICTION USING MODEL )

S401
ARE THERE ONE OR MORE MODELS? —NO→

↓YES

S402
IS THERE MODEL NOT APPLIED TO THIS DATA? —NO→

↓YES

S403
READ OUT MODEL FROM SAVE AREA

↓

S404
←NO— IS MODEL VALID?

↓YES

S405
CALCULATE PREDICTED OUTPUT VALUE USING MODEL

↓

S406
NO— IS CALCULATION RESULT VALID?

↓YES

S407
SAVE CALCULATION RESULT IN SAVE AREA

↓

( END )

# F I G. 9

```
      ┌─────────────────────────────┐
      │   ABNORMALITY DETECTION     │
      │        PROCESSING           │
      └─────────────────────────────┘
                   │
                   ▼
              ◇ S501
         ARE THERE ONE
    OR MORE PREDICTED OUTPUT ──── NO ──┐
          VALUES?                      │
                   │                   │
                  YES                  │
                   │  S502             │
      ┌─────────────────────────────┐ │
      │    READ OUT OUTPUT VALUE    │ │
      └─────────────────────────────┘ │
                   │  S503             │
      ┌─────────────────────────────┐ │
      │  CALCULATE EVALUATION VALUE │ │
      └─────────────────────────────┘ │
                   │  S504             │
      ┌─────────────────────────────┐ │
      │ SAVE EVALUATION VALUE IN     │ │
      │       SAVE AREA             │ │
      └─────────────────────────────┘ │
                   │  S505             │
      ┌─────────────────────────────┐ │
      │     DETECT ABNORMALITY      │ │
      └─────────────────────────────┘ │
                   │  S506             │
      ┌─────────────────────────────┐ │
      │ NOTIFY DETERMINATION RESULT │ │
      └─────────────────────────────┘ │
                   │◄──────────────────┘
                   ▼
              ┌─────────┐
              │   END   │
              └─────────┘
```

FIG. 10

EP 4 089 496 A1

# FIG. 11

EP 4 089 496 A1

## INTERNATIONAL SEARCH REPORT

| International application No. |
| --- |
| PCT/JP2021/007403 |

**A. CLASSIFICATION OF SUBJECT MATTER**
Int.Cl. G05B23/02(2006.01)i
FI: G05B23/02302R

According to International Patent Classification (IPC) or to both national classification and IPC

**B. FIELDS SEARCHED**

Minimum documentation searched (classification system followed by classification symbols)
Int.Cl. G05B23/02

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | JP 2019-159786 A (NEC CORPORATION) 19 September 2019 (2019-09-19), paragraphs [0013]-[0035], fig. 1-11 | 1-2, 15-19<br>3-14 |
| Y | WO 2014/141682 A1 (NEC CORPORATION) 18 September 2014 (2014-09-18), claims, paragraphs [0054]-[0057] | 3-14 |
| A | JP 2016-218636 A (NEC CORPORATION) 22 December 2016 (2016-12-22), entire text, all drawings | 1-19 |

☐ Further documents are listed in the continuation of Box C.    ☒ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 15 April 2021 | 27 April 2021 |

| Name and mailing address of the ISA/ | Authorized officer |
| --- | --- |
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

Information on patent family members

International application No.

PCT/JP2021/007403

```
JP 2019-159786 A   19 September 2019   (Family: none)

WO 2014/141682 A1  18 September 2014   (Family: none)

JP 2016-218636 A   22 December 2016    (Family: none)
```

Form PCT/ISA/210 (patent family annex) (January 2015)

**EP 4 089 496 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017021702 A
- JP 2020037158 A